Europäisches Patentamt

European Patent Office

Office européen des brevets

(19)

(11) Veröffentlichungsnummer: **0 205 184 B1**

(12) **EUROPÄISCHE PATENTSCHRIFT**

(45) Veröffentlichungstag der Patentschrift: **04.09.91**

(21) Anmeldenummer: **86108125.5**

(22) Anmeldetag: **13.06.86**

(51) Int. Cl.5: **H01J 37/28**, G01R 31/28, H01J 49/06, H01J 37/10

(54) **Abberrationsarmes Spektrometer-Objektiv hoher Sekundärelektronen-Akzeptanz.**

(30) Priorität: **14.06.85 DE 3521439**

(43) Veröffentlichungstag der Anmeldung:
**17.12.86 Patentblatt 86/51**

(45) Bekanntmachung des Hinweises auf die Patenterteilung:
**04.09.91 Patentblatt 91/36**

(84) Benannte Vertragsstaaten:
**DE FR GB IT NL SE**

(56) Entgegenhaltungen:
**US-A- 3 582 649**
**US-A- 4 554 455**

(73) Patentinhaber: **ICT Integrated Circuit Testing Gesellschaft für Halbleiterprüftechnik mbH Klausnerring 1a W-8011 Heimstetten(DE)**

(72) Erfinder: **Plies, Erich, Dr. Dipl.-Phys. Deisenhofenerstrasse 79c W-8000 München 90(DE)**

(74) Vertreter: **Tetzner, Volkmar, Dr.-Ing. Dr. jur. Van-Gogh-Strasse 3 W-8000 München 71(DE)**

## Beschreibung

Die Erfindung betrifft ein aberrationsarmes Spektrometer-Objektiv hoher Sekundärelektronen-Akzeptanz nach dem Oberbegriff des Patentanspruchs 1.

Für quantitative Potentialmessungen an Knotenpunkten und Leiterbahnen in hochintegrierten Schaltungen werden gegenwärtig konventionelle, mit Strahlaustastsystemen und Gegenfeld-Spektrometern ausgerüstete Raster-Elektronenmikroskope eingesetzt. Mit modifizierten Raster-Elektronenmikroskopen lassen sich genügend feine Elektronensonden zur Untersuchung höchstintegrierter Schaltungen mit Strukturen im Sub-Mikrobereich allerdings nicht erzeugen, da diese Geräte zur Vermeidung von Strahlenschäden und Aufladungen der zumeist auf isolierenden Trägersubstanzen angeordneten Bauelemente bei niedrigen Primärelektronenen-Energien betrieben werden müssen. Eine deutliche Verbesserung der im wesentlichen durch den axialen Farbfehler der Objektivlinse und die Elektron-Elektron-Wechselwirkung(Boersch-Effekt) begrenzten Ortsauflösung ist nur durch einen kurzen elektronenoptischen Strahlengang mit wenigen Strahlüberkreuzungspunkten und einer Objektivlinse kurzer Brennweite erreichbar. Der Einsatz kurzbrennweitiger Objektivlinsen mit kurzem Arbeitsabstand zur Reduktion der im wesentlichen durch Brennweite und Arbeitsabstand bestimmten chromatischen und sphärischen Bildfehler scheiterte bisher am Aufbau konventioneller Elektronenstrahl-Meßgeräte, bei denen zwischen Objektivlinse und Probe ein Sekundärelektronen-Spektrometer angeordnet ist.

Erst durch die Entwicklung von Objektivlinsen mit integriertem Sekundärelektronen-Spektrometer (Spektrometer-Objektiv) konnte mit dem Arbeitsabstand die Aberration der Objektivlinse reduziert und damit der Sondendurchmesser auf der Probe verkleinert werden. Ein solches Spektrometer-Objektiv ist aus der Veröffentlichung von Kawamoto "Electron Beam Tester with In the Lens Analyzer" in den Proceedings of the Simposium on Electron-Beam-Testing, 9.-10. Nov. 1984, Osaka, Japan, S. 69-72, bekannt.

Bei dieser bekannten Anordnung handelt es sich um eine magnetische Objektivlinse kurzer Brennweite mit integriertem Parallelplatten-Analysator und einer oberhalb der Objektivlinse angeordneten Elektrode zur Ablenkung der Sekundärelektronen in Richtung eines Detektors.

In diesem bekannten Spektrometer-Objektiv mit ebener Absaug- und Gegenfeldelektrode ist allerdings kein winkelunabhängiger Nachweis der auf der Probe ausgelösten und in einen größeren Raumwinkelbereich emittierten Sekundärelektronen möglich, so daß die erreichbare Potentialauflösung infolge der hierdurch verursachten Meßfehler begrenzt wird.

Der Erfindung liegt die Aufgabe zugrunde, ein aberration sarmes Spektrometer-Objektiv der eingangs genannten Art anzugeben, das eine hohe Sekundärelektronen-Akzeptanz aufweist und mit dem die Sekundärelektronen unabhängig von ihrer Emissionsrichtung an der Meßstelle winkelunabhängig nachgewiesen werden können.

Diese Aufgabe wird erfindungsgemäß durch ein Spektrometer-Objektiv der eingangs genannten Art gelöst, welches die kennzeichnenden Merkmale des Patentanspruchs 1 aufweist.

Der mit der Erfindung erzielbare Vorteil besteht insbesondere darin, daß der Durchmesser der in der elektronenoptischen Säule eines Elektronenstrahl-Meßgerätes erzeugten Elektronensonde auf der Probe reduziert und die Potentialauflösung durch den winkelunabhängigen Nachweis der Sekundärelektronen deutlich gesteigert werden kann.

Die Ansprüche 2 bis 10 sind auf bevorzugte Ausgestaltungen und Weiterbildungen der Erfindung gerichtet.

Das erfindungsgemäße Spektrometer-Objektiv wird nachfolgend anhand der Zeichnungen erläutert. Dabei zeigt:

Fig. 1   ein erstes Ausführungsbeispiel eines erfindungsgemäßen Spektrometer-Objektivs,

Fig.2   den elektrischen und magnetischen Feldverlauf innerhalb eines Spektrometer-Objektivs nach Fig.1,

Fig.3   ein zweites Ausführungsbeispiel eines erfindungsgemäßen Spektrometer-Objektivs,

Fig.4   das Ablenkelement eines Spektrometer-Objektivs nach Fig.3.

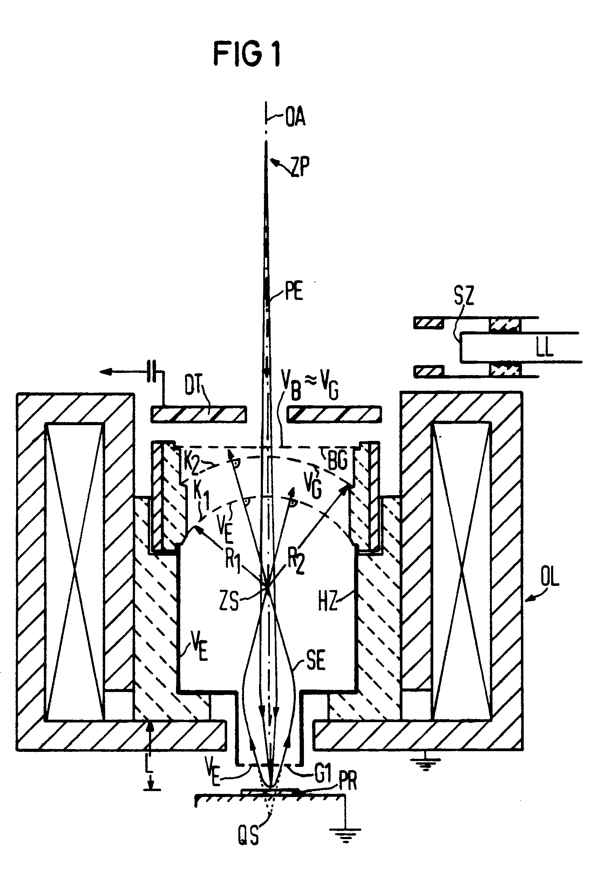

Das in Fig.1 dargestellte Ausführungsbeispiel eines erfindungsgemäßen Spektrometer-Objektivs besteht aus einer kurzbrennweitigen magnetischen Objektivlinse OL und einer innerhalb dieser Magnetlinse angeordneten Spektrometer-Detektoranordnung. Dieses Gesamtsystem bildet eine elektronenoptische Einheit, mit der sowohl die in einer Quelle erzeugten Primärelektronen PE als auch die auf einer Probe PR ausgelösten Sekundärelektronen SE in einen auf der optischen Achse OA liegenden Punkt fokussiert werden.Zur Erzeugung einer feinen Elektronensonde bildet man das durch Kondensorlinsen erzeugte Zwischenbild ZP der Elektronenquelle mit Hilfe des Spektrometer-Objektivs als Teil des strahlformenden Systems verkleinert auf die in der Brennebene der Objektivlinse OL angeordneten Probe PR ab. Mit dem erfindungsgemäßen Spektrometer-Objektiv läßt sich ein im Vergleich zu konventionellen Anordnungen sehr kurzer, die chromatischen und sphärischen Bildfehler der Objektivlinse OL und damit den Sondendurchmesser auf der Probe PR entscheidend beeinflussender Arbeitsabstand L erzielen. Zum Nachweis der am Meßpunkt von den hochenergetischen Primärelektronen PE infolge ihrer Wechselwirkung mit der Festkörpersubstanz ausgelösten und in den gesamten Raumwinkelbereich oberhalb der Probe PR emittierten niederenergetischen Sekundärelektronen SE werden diese im elektrischen Feld einer zwischen den Polschuhen der Objektivlinse OL herausragenden ebenen Netzelektrode G1 abgesaugt und in Richtung der optischen Achse OA auf relativ hohe Energien von typischerweise 1 bis 2 keV beschleunigt. Die hochenergetischen Sekundärelektronen SE durchlaufen die Netzelektrode G1 und gelangen in das die Sekundärelektronen SE in einen auf der optischen Achse OA innerhalb der Objektivlinse liegenden Punkt ZS fokussierende Magnetfeld zwischen den Polschuhen. Die Lage dieses Fokussierungspunktes ZS, der als reelles Zwischenbild der unterhalb der Probe PR liegenden virtuellen Sekundärelektronen-Quelle QS zu interpretieren ist, wird bestimmt von der Höhe der positiven Netzelektroden-Spannung $V_E$ und der von der Primärelektronen-Energie abhängigen Magnetfeldstärke zwischen den Polschuhen der Objektivlinse OL. Die virtuelle Quelle QS ist hierbei durch den kleinsten Kaustikquerschnitt aller virtuellen Sekundärelektronen-Trajektorien unterhalb der Probe PR definiert. Die gemeinsame Fokussierung aller Sekundärelektronen SE im Feld der Objektivlinse OL ist überhaupt nur durch deren Beschleunigung auf hohe kinetische Energien möglich ($E_{SE}$ = 1 bis 2 keV), da nur dann die relative Energiebreite $\Delta E/\overline{E}$ ($\overline{E}$ = mittlere kinetische Energie der Sekundärelektronen SE) soweit reduziert wird, daß die Bildweiten der am Meßpunkt mit unterschiedlichen kinetischen Energien emittierten Sekundärelektronen SE noch nahezu zusammenfallen.

Die winkelunabhängige Abbremsung und Energieanalyse der Sekundärelektronen SE erfolgt innerhalb der Objektivlinse OL in einem kugelsymmetrischen elektrischen Gegenfeld, das in dem Raumbereich zwischen zwei kugelsymmetrischen, auf unterschiedlichem Potential liegenden Netzelektroden K1 und K2 aufgebaut wird. Derartige Elektrodenanordnungen sind beispielsweise aus der US-PS 4 464 571 und der US-A-3.582.649 bekannt. Die untere Netzelektrode K1 ist erfindungsgemäß über einen sich im Polschuhspalt verjüngenden und konzentrisch zur optischen Achse OA angeordneten Hohlzylinder HZ leitend mit der Absaugelektrode G1 verbunden, so daß zwischen diesen Elektroden ein von elektrischen Feldern freier Raum innerhalb der Objektivlinse OL entsteht. Die obere kugelsymmetrische Netzelektrode K2 wirkt als Gegenfeld-Gitter und liegt typischerweise auf einem Potential $V_G$ zwischen etwa -15 und +15 V (Volt). Oberhalb der das Gegenfeld aufbauenden Elektrodenanordnung kann noch ein auf etwa gleichem Potential $V_B$ - wie die obere Kugelelektrode K2 - liegendes Abschirmgitter BG vorgesehen sein.

Ein winkelunabhängiger Nachweis der Sekundärelektronen SE kann nur dann erfolgen, wenn die Sekundärelektronen-Trajektorien parallel zu den elektrischen Feldlinien des Gegenfeldes und damit senkrecht zur Oberfläche der kugelsymmetrischen Netzelektroden K1 und K2 verlaufen. Um dies zu erreichen, wird der virtuelle Quellpunkt QS der Sekundärelektronen SE in das Zentrum (ZS) des sphärischen Gegenfeldes, d.h. in den auf der optischen Achse OA oberhalb der Polschuhe liegenden Mittelpunkt der kugelsymmetrischen Netzelektroden K1 und K2, abgebildet. Weiterhin ist zu beachten, daß das reelle Zwischenbild in punkt ZS der Sekundärelektronen SE auf der optischen Achse OA genügend weit oberhalb des Polschuhspaltes der Objektivlinse OL in einem Raumbereich mit verschwindender magnetischer Induktion B liegt, um eine Larmor-Präzision der Sekundärelektronen SE nach Durchlaufen dieses Zwischenbildes ZS zu vermeiden. Die Fokussierung der Sekundärelektronen SE in einen Punkt ZS der optischen Achse OA, der in einem Raumbereich mit verschwindendem $B_Z(O,O,z)$ liegt, ist umso besser möglich, je kleiner die Energie der Primärelektronen PE und je höher das die Sekundärelektronen beschleunigende Absaugpotential $V_E$ der Netzelektrode G1 ist.

Zum Nachweis der Sekundärelektronen SE ist innerhalb des erfindungsgemäßen Spektrometer-Objektives ein konzentrisch zur optischen Achse OA angeordneter ringförmiger Detektor DT vorgesehen. Hierfür besonders geeignet sind beispielsweise Halbleiter-Detektoren, Channel-Plates oder Metallplatten mit Elektronenfallen. Außer diesem ringförmigen Sekundärelektronen-Detektor DT kann außerhalb des Spektrometer-Objektives noch ein weiterer konventioneller Sekundärelektronen-Detektor, beispielsweise eine Anordnung aus Szintillator SZ und Lichtleiter LL, zum Nachweis der in Richtung der optischen Achse OA emittierten Sekundärelektronen SE vorgesehen sein.

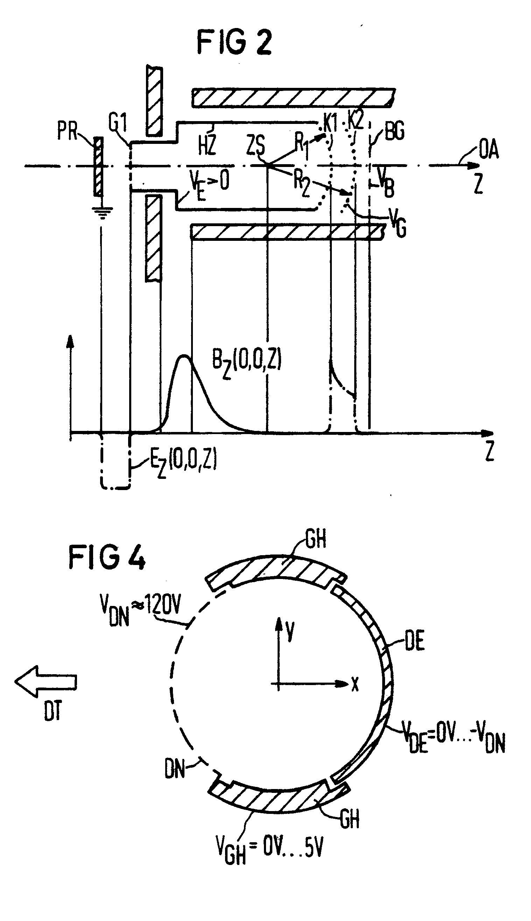

In Fig.2 ist der Verlauf der magnetischen Induktion $B_Z(O,O,z)$ (ausgezogene Linie) und der elektrischen Feldstärke $E_Z(O,O,z)$ (strichpunktierte Linie) zwischen Probe PR und Abschirmgitter BG in Richtung der optischen Achse OA für ein erfindungsgemäßes Spektrometer-Objektiv nach Fig.1 dargestellt. Das Zentrum des sphärischen Gegenfeldes ZS liegt auf der optischen Achse OA in einem Raumbereich, in dem die magnetische Induktion $B_Z(O,O,z)$ verschwindet. Hierdurch wird eine Larmor-Präzision der Sekundärelektronen SE nach Durchlaufen des Zwischenbildes ZS vermieden, so daß deren Trajektorien parallel zu den elektrischen Feldlinien des kugelsymmetrischen Gegenfeldes verlaufen.

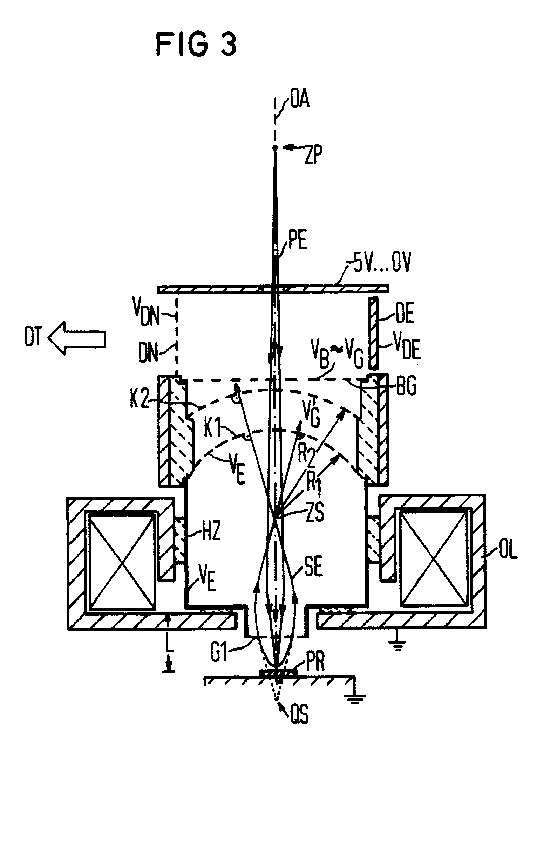

Ein weiteres Ausführungsbeispiel eines erfindungsgemäßen Spektrometer-Objektives ist in Fig.3 dargestellt. Auch in dieser Anordnung wird der virtuelle Quellpunkt QS der Sekundärelektronen SE in das innerhalb des Spektrometer-Objektives liegende Zentrum (ZS) des kugelsymmetrischen Gegenfeldes abgebildet. Dieses Zentrum (ZS) des sphärischen Gegenfeldes, das mit dem Mittelpunkt der unmittelbar oberhalb der Objektivlinse OL angeordneten kugelsymmetrischen Elektroden K1 und K2 zusammenfällt, liegt innerhalb der Objektivlinse OL auf der optischen Achse in einem Raumbereich, in dem die magnetische Induktion B und das elektrische Feld E verschwinden. Die Absaugelektrode G1 und die untere kugelsymmetrische Elektrode K1 sind wieder durch einen sich im Polschuhspalt verjüngenden und konzentrisch zur optischen Achse OA angeordneten Hohlzylinder HZ leitend miteinander verbunden, so daß im Innern der Objektivlinse OL ein von elektrischen Feldern freier Raum entsteht. Oberhalb der das kugelsymmetrische Gegenfeld erzeugenden Elektroden K1 und K2 befindet sich eine Elektrodenanordnung zur Ablenkung und Beschleunigung der Sekundärelektronen SE in Richtung eines in Fig.2 nicht dargestellten Detektors DT. Dieses Ablenkelement, das in Fig.4 im Schnitt senkrecht zur optischen Achse OA dargestellt ist, besteht vorteilhafterweise aus einer auf positivem Potential $V_{DN}$ liegenden Netzelektrode DN und einer symmetrisch dazu angeordneten, auf negativem Potential $V_{DE}$ liegenden Ablenkelektrode DE, die zusammen mit den zwischen diesen Elektroden liegenden Gehäuseteilen GH die Mantelfläche eines konzentrisch zur optischen Achse OA angeordneten Hohlzylinders bilden. An die Netzelektrode DN und die Ablenkelektrode DE werden vorteilhafterweise dem Betrag nach gleiche Spannungen $|V_{DE}| = |V_{DN}|$ zwischen 100 und 150 V (Volt) angelegt. Um Durchgriffe des Netzelektroden-Potentials $V_{DN}$ in den Raum zwischen den kugelsymmetrischen Elektroden K1 und K2 zu vermeiden, kann noch ein Abschirmgitter BG zwischen dem Ablenkteil und der Netzelektrode K2 vorgesehen sein. Dieses Abschirmgitter BG liegt auf etwa dem gleichen Potential wie die Kugelelektrode K2 ($V_G \approx V_B$).

## Patentansprüche

1. Spektrometer-Objektiv für quantitative Potentialmessungen in der Elektronenstrahl-Meßtechnik, bei dem eine magnetische Objektivlinse (OL) mit Polschuhen zur Fokussierung eines Primärelektronenstrahles (PE) auf eine Probe (PR) und ein elektrostatisches Gegenfeld-Spektrometer, das eine Elektrodenanordnung (G1) zum Absaugen der an einer Meßstelle vom Primärelektronenstrahl (PE) ausgelösten Sekundärelektronen (SE) und eine Elektrodenanordnung (K1, K2) zur Erzeugung eines die Sekundärelektronen (SE) abbremsenden elektrischen Gegenfeldes aufweist, eine elektronenoptische Einheit bilden, und dem eine Detektoranordnung zum Nachweis der Sekundärelektronen (SE) zugeordnet ist,
dadurch **gekennzeichnet,**
- daß die Gegenfeld-Elektrodenanordnung zwei kugelsymmetrische Elektroden (K1, K2) aufweist, deren Potentiale ($V_D$, $V_E$) so gewählt sind, daß sich im Raum zwischen diesen Elektroden ein kugelsymmetrisches Gegenfeld aufbaut,
- daß die Mittelpunkte dieser kugelsymmetrischen Elektroden (K1, K2) in einem auf der optischen Achse (OA) des Spektrometer-Objektivs oberhalb der Polschuhe liegenden Punkt (ZS) zusammenfallen,
- daß dieser, das Zentrum (ZS) des kugelsymmetrischen Gegenfeldes definierende Punkt (ZS) in einem von elektrischen Feldern freien Raum innerhalb der Objektivlinse (OL) liegt in einem Raumbereich mit verschwindender magnetischer Induktion und
- daß die im elektrischen Feld der Absaugelektrodenanordnung (G1) beschleunigten Sekundärelektronen (SE) im magnetischen Feld der Objektivlinse (OL) in das Zentrum (ZS) des kugelsymmetrischen Gegenfeldes fokussiert werden.

2. Spektrometer-Objektiv nach Anspruch 1, dadurch **gekennzeichnet,** daß zur Erzeugung eines von elektrischen Feldern freien Raumes im Innern der Objektivlinse (OL) die Elektrodenanordnung (G1) zum Absaugen der Sekundärelektronen (SE) und die der Probe (PR) nächstliegende kugelsymmetrische Elektrode (K1) durch einen, sich im Polschuhspalt verjüngenden und konzentrisch zur optischen Achse angeordneten Hohlzylinder (HZ) leitend verbunden sind.

3. Spektrometer-Objektiv nach Anspruch 1 oder 2, dadurch **gekennzeichnet,** daß die ein kugelsymmetrisches Gegenfeld aufbauende Elektrodenanordnung (K1, K2) oberhalb der Polschuhe im Innern der Objektivlinse (OL) angeordnet ist.

4. Spektrometer-Objektiv nach einem der Ansprüche 1 bis 3, dadurch **gekennzeichnet,** daß ein konzentrisch zur optischen Achse angeordneter ringförmiger Sekundärelektronen-Detektor (DT) oberhalb der das kugelsymmetrische Gegenfeld aufbauenden Elektrodenanordnung (K1, K2) im Innern der Objektivlinse (OL) vorgesehen ist.

5. Spektrometer-Objektiv nach einem der Ansprüche 1 bis 5, dadurch **gekennzeichnet,** daß oberhalb des konzentrisch zur optischen Achse im Innern der Objektivlinse (OL) angeordneten ringförmigen Sekundärelektronen-Detektors (DT) ein weiterer Sekundärelektronen-Detektor vorgesehen ist.

6. Spektrometer-Objektiv nach einem der Ansprüche 1 bis 5, dadurch **gekennzeichnet,** daß zwischen der ein kugelsymmetrisches Gegenfeld aufbauenden Elektrodenanordnung (K1, K2) und dem ringförmigen Sekundärelektronen-Detektor (DT) eine Abschirmgitter (BG) vorgesehen ist.

7. Spektrometer-Objektiv nach Anspruch 1 oder 2, dadurch **gekennzeichnet,** daß die ein kugelsymmetrisches Gegenfeld aufbauende Elektrodenanordnung (K1, K2) unmittelbar oberhalb der Objektivlinse (OL) angeordnet ist.

8. Spektrometer-Objektiv nach Anspruch 7, dadurch **gekennzeichnet,** daß oberhalb der ein kugelsymmetrisches Gegenfeld aufbauenden Elektrodenanordnung (K1, K2) eine Anordnung (DE, DN) zur Ablenkung und Beschleunigung der Sekundärelektronen (SE) in Richtung eines Detektors (DT) vorgesehen ist.

9. Spektrometer-Objektiv nach Anspruch 7 oder 8, dadurch **gekennzeichnet,** daß die Anordnung (DE, DN) zur Ablenkung und Beschleunigung der Sekundärelektronen (SE) in Richtung eines Detektors (DT) eine auf positivem Potential ($V_{DN}$) liegende Netzelektrode (DN) und eine symmetrisch dazu angeordnete, auf negativem Potential ($V_{DE}$) liegende Ablenkelektrode (DE) aufweist, die zusammen mit den zwischen diesen Elektroden (DE, DN) angeordneten Gehäuseteilen (GH) die Mantelfläche eines Hohlzylinders bilden, dessen Symmetrieachse mit der optischen Achse (OA) zusammenfällt.

10. Spektrometer-Objektiv nach einem der Ansprüche 7 bis 9, dadurch **gekennzeichnet,** daß zwischen der ein kugelsymmetrisches Gegenfeld aufbauenden Elektrodenanordnung (K1, K2) und der Anordnung (DE, DN) zur Ablenkung und Beschleunigung der Sekundärelektronen (SE) in Richtung eines Detektors (DT) eine Abschirmgitter (BG) vorgesehen ist.

## Claims

1. Spectrometer objective for quantitative measurements of potential in electron beam measuring technology, in which an electron-optical unit is formed by a magnetic objective lens (OL) with pole pieces for focusing a primary electron beam (PE) onto a specimen (PR) and an electrostatic retarding field spectrometer having an electrode arrangement (G1) for extraction of the secondary electrons (SE) generated at a measuring point by the primary electron beam (PE) and electrode arrangement (K1, K2) for generating an electrical retarding field which retards the secondary electrons (SE), a detector arrangement being associated with the spectrometer objective for detection of the secondary electrons (SE), characterised in that:
   - the retarding field electrode arrangement has two spherically symmetrical electrodes (K1, K2) which have potentials ($V_D$, $V_E$) which are chosen so that a a spherically symmetrical retarding field builds up in the space between these electrodes,
   - the central points of these spherically symmetrical electrodes (K1, K2) coincide in a point (ZS) which lies on the optical axis (OA) of the spectrometer objective above the pole pieces,
   - this point (ZS) which defines the centre (ZS) of the spherically symmetrical retarding field lies in a space which is free of electrical fields within the objective lens (OL) in a spatial region with disappearing magnetic induction, and
   - the secondary electrons (SE) which are accelerated in the electrical field of the extraction electrode arrangement (G1) are focused in the magnetic field of the objective lens (OL) into the centre (ZS) of the spherically symmetrical retarding field.

2. Spectrometer objective as claimed in claim 1, characterised in that in order to generate a space which is free of electrical fields in the interior of the objective lens (OL) the electrode arrangement (G1) for extraction of the secondary electrons (SE) and the spherically symmetrical electrode (K1) lying nearest to the specimen (PR) are conductively connected by a hollow cylinder (HZ) which is arranged concentrically with respect to the optical axis and tapers in the pole piece gap.

3. Spectrometer objective as claimed in claims 1 or 2, characterised in that the electrode arrangement (K1, K2) which builds up a spherically symmetrical retarding field is arranged above the pole shoes in the interior of the objective lens (OL).

4. Spectrometer objective as claimed in one of claims 1 to 3, characterised in that an annular secondary electron detector (DT) which is arranged concentrically with respect to the optical axis is provided in the interior of the objective lens (OL) above the electrode arrangement (K1, K2) which builds up the spherically symmetrical retarding field.

5. Spectrometer objective as claimed in one of claims 1 to 5, characterised in that a further secondary electron detector is provided above the annular secondary electron detector (DT) which is arranged concentrically with respect to the optical axis in the interior of the objective lens (OL).

6. Spectrometer objective as claimed in one of claims 1 to 5, characterised in that a buffer grid (BG) is provided between the electrode arrangement (K1, K2) which builds up a spherically symmetrical opposing field and the annular secondary electron detector (DT).

7. Spectrometer objective as claimed in claims 1 or 2, characterised in that the electrode arrangement (K1, K2) which builds up a spherically symmetrical retarding field is arranged immediately above the objective lens (OL).

8. Spectrometer objective as claimed in claim 7, characterised in that an arrangement (DE, DN) for deflection and acceleration of the secondary electrons (SE) in the direction of a detector (DT) is provided above the electrode arrangement (K1, K2) which builds up a spherically symmetrical retarding field.

9. Spectrometer objective as claimed in claims 7 or 8, characterised in that the arrangement (DE, DN) for deflection and acceleration of the secondary electrons (SE) in the direction of a detector (DT) has a grid electrode (DN) which has a positive potential ($V_{DN}$) and a deflector electrode (DE) which is arranged symmetrically with respect thereto and has a negative potential ($V_{DE}$), these two electrodes together with the housing parts (GH) lying between them forming the generated surface of a hollow cylinder whose axis of symmetry coincides with the optical axis (OA).

10. Spectrometer objective as claimed in claim 1, characterised in that a buffer grid (BG) is provided between the electrode arrangement (K1, K2) which builds up a spherically symmetrical retarding field and the arrangement (DE, DN) for deflection and acceleration of the secondary electrons (SE) in the direction of a detector (DT).

**Revendications**

1. Objectif à spectromètre pour mesures quantitatives de potentiel en technique de mesure à faisceau d'électrons, dans lequel une lentille magnétique de l'objectif (OL) comprenant des pièces polaires de focalisation d'un faisceau d'électrons primaires (PE) sur un échantillon (PE) et un spectromètre électrostatique à champ antagoniste, qui comprend un montage d'électrode (G1) de pompage des électrons secondaires (SE) libérés du faisceau d'électrons primaires (PE) en un point de mesure et un montage d'électrodes (K1, K2) de production d'un champ électrique antagoniste de freinage des électrons secondaires (SE), forment une unitè opto-électronique, ledit objectif étant combiné avec un montage détecteur d'identification des électrons secondaires (SE),
   caractérisé en ce que
   - le montage d'électrodes à champ antagoniste comprend deux électrodes (K1, K2) à symétrie sphérique, dont les potentiels ($V_D$, $V_E$) sont choisis de manière qu'il se crée un champ antagoniste à symétrie sphérique dans le volume compris entre ces électrodes,
   - les centres de ces électrodes (K1, K2) à symétrie sphérique coincident en un point (ZS) situé sur l'axe optique (OA) de l'objectif à spectromètre, au-dessus des pièces polaires,
   - le point (ZS) définissant le centre (ZS) du champ antagoniste à symétrie sphérique est placé dans un volume exempt de champs électriques qui est situé à l'intérieur de la lentille de l'objectif (OL), dans un espace à induction magnétique s'évanouissant, et
   - les électrons secondaires (SE) accélérés dans le champ électrique du montage d'électrode de pompage (G1) sont focalisés dans le champ magnétique de la lentille de l'objectif (OL) au centre (ZS) du champ antagoniste à symétrie sphérique.

2. Objectif à spectromètre selon la revendication 1, caractérisé en ce qu'un cylindre creux (HZ) disposé concentriquement à l'axe optique et se rétrécissant dans l'intervalle entre pièces polaires connecte le montage d'électrode (G1) de pompage des électrons secondaires (SE) et l'électrode (K1) à symétrie sphérique qui est la plus proche de l'échantillon (PR) afin de produire un volume exempt de champs électriques à l'intérieur de la lentille de l'objectif (OL).

3. Objectif à spectromètre selon la revendication 1 ou 2, caractérisé en ce que le montage d'électrodes (K1, K2) destiné à créer un champ antagoniste à symétrie sphérique est disposé au-dessus des pièces polaires, à l'intérieur de la lentille de l'objectif (OL).

4. Objectif à spectromètre selon l'une des revendications 1 à 3, caractérisé en ce qu'un détecteur annulaire (DT) des électrons secondaires, qui est disposé concentriquement à l'axe optique, est prévu à l'intérieur de la lentille de l'objectif (OL) au-dessus du montage d'électrodes (K1, K2) qui crée le champ antagoniste à symétrie sphérique.

5. Objectif à spectromètre selon l'une des revendications 1 à 5, caractérisé en ce qu'un autre détecteur des électrons secondaires est prévu au-dessus du détecteur annulaire d'électrons secondaires disposé concentriquement à l'axe optique, à l'intérieur de la lentille de l'objectif (OL).

6. Objectif à spectromètre selon l'une des revendications 1 à 5, caractérisé en ce qu'une grille écran (DG) est prévue entre le montage d'électrodes (K1, K2 ) créant un champ antagoniste à symétrie sphérique et le détecteur annulaire (DT) d'électrons secondaires.

7. Objectif à spectromètre selon la revendication 1 ou 2, caractérisé en ce que le montage d'électrodes (K1, K2) créant un champ antagoniste à symétrie sphérique est disposé immédiatement au-dessus de la lentille de l'objectif (OL).

8. Objectif à spectromètre selon la revendication 7, caractérisé en ce qu'un montage (DE, DN) de déviation et d'accélération des électrons secondaires (SE) vers un détecteur (DT) est prévu au-dessus du montage d'électrodes (K1, K2) créant un champ antagoniste à symétrie sphérique.

9. Objectif à spectromètre selon la revendication 7 ou 8, caractérisé en ce que le montage (DE, DN) de déviation et d'accélération des électrons secondaires (SE) vers un détecteur (DT) comprend une électrode réticulaire (DN) qui est à un potentiel positif ($V_{DN}$) et une électrode de déviation (DE) disposée symétriquement à la précédente et qui est à un potentiel négatif ($V_{DE}$), ces électrodes (DE, DN) formant avec les éléments de cage (GH) disposés entre elles l'enveloppe d'un cylindre creux dont l'axe de symétrie coincide avec l'axe optique (OA).

10. Objectif à spectromètre selon l'une des revendications 7 à 9, caractérisé en ce qu'une grille écran (BG) est prévue entre le montage d'électrodes (K1, K2) créant un champ antagoniste à symétrie sphérique et le montage (DE, DN) de déviation et d'accélération des électrons secondaires (SE) vers un détecteur (DT).

# FIG 1

## FIG 2

## FIG 4

## FIG 3